# FASCICULE DE BREVET EUROPEEN

(11) **EP 1 439 580 B1**
(45) Date de publication et mention de la délivrance du brevet: **12.10.2005**
(21) Numéro de dépôt: 03300215.5
(22) Date de dépôt: 14.11.2003
(51) Int. Cl.: H01L 21/8242, H01L 21/334, H01L 21/762

(54) **Réalisation de tranchées fines et rapprochées**
Herstellung feiner und dicht angeordneter Gräben
Fabrication of fine and narrow-spaced trenches

(30) Priorité: 19.11.2002 FR 0214460
(43) Date de publication de la demande: 21.07.2004
(73) Titulaire: STMicroelectronics S.A., 92120 Montrouge (FR)
(72) Inventeur: Poveda, Patrick, 37110 Villedomer (FR)
(74) Mandataire: de Beaumont, Michel

(56) Documents cités:
- US-A- 4 650 544
- US-A- 5 793 077
- US-B1- 6 175 144
- US-B1- 6 316 309

## Description

La présente invention concerne la réalisation de tranchées étroites et rapprochées dans un substrat semiconducteur.

La largeur minimale d'une tranchée et l'espacement entre tranchées dépendent de façon classique du dispositif de lithographie utilisé pour insoler des résines photosensibles. Plus l'insolation est précise, plus il est possible d'obtenir des tranchées très étroites après gravure.

Dans la mesure où il n'est pas forcément possible de se procurer un dispositif de lithographie permettant d'obtenir des tranchées étroites, la présente invention a pour objet de réaliser des tranchées ayant une largeur inférieure à la largeur minimale normalement possible avec un dispositif de lithographie donné.

Pour atteindre cet objet, la présente invention prévoit un procédé de formation de tranchées étroites dans un substrat de silicium comprenant les étapes de gravure du substrat pour former des premières tranchées séparées par des premières nervures de silicium ; d'oxydation thermique du substrat pour former une couche d'oxyde de silicium se développant dans et à l'extérieur du silicium, d'où il résulte que l'on obtient des secondes tranchées plus étroites que les premières tranchées et des secondes nervures de silicium plus étroites que les premières nervures de silicium ; de remplissage des secondes tranchées avec des doigts d'un matériau gravable ; de gravure de l'oxyde de silicium jusqu'à la surface supérieure des secondes nervures en conservant des portions d'oxyde de silicium entre lesdits doigts de matériau gravable et les secondes nervures ; d'élimination par gravure des secondes nervures de silicium et desdits doigts de matériau gravable ; de gravure de l'oxyde de silicium pendant une durée suffisante pour découvrir le substrat au fond des portions d'oxyde de silicium, en laissant en place des doigts d'oxyde de silicium ; et de gravure anisotrope du substrat entre les doigts d'oxyde pour former des tranchées étroites dans le substrat.

Selon une variante de mise en oeuvre du procédé précédemment décrit, l'étape de remplissage est effectuée selon les deux étapes suivantes : dépôt d'une couche de matériau gravable remplissant totalement les secondes tranchées et recouvrant la couche d'oxyde de silicium ; et gravure de ladite couche de matériau gravable pendant une durée suffisante pour laisser en place seulement des doigts dans les secondes tranchées.

Selon une variante de mise en oeuvre du procédé précédemment décrit, une étape supplémentaire de retrait desdits doigts d'oxyde de silicium est prévue.

Selon une variante de mise en oeuvre du procédé précédemment décrit, le procédé comprend en outre les étapes suivantes : dépôt d'une couche de remplissage composée d'un matériau gravable sélectivement par rapport au substrat, la couche de remplissage remplissant totalement les tranchées étroites et recouvrant les nervures du substrat séparant les tranchées étroites ; gravure de la couche de remplissage jusqu'à découvrir les nervures du substrat, en conservant le matériau présent entre les nervures ; polissage mécano-chimique de la partie supérieure des nervures ; et retrait du matériau restant entre les nervures.

Selon une variante de mise en oeuvre du procédé précédemment décrit, la largeur et l'espacement des premières tranchées sont identiques et la durée de l'oxydation thermique du substrat est prévue de façon à obtenir des tranchées étroites sensiblement identiques.

Selon une variante de mise en oeuvre du procédé précédemment décrit, le matériau gravable utilisé pour remplir les secondes tranchées est du silicium polycristallin.

Selon une variante de mise en oeuvre du procédé précédemment décrit, les secondes nervures de silicium et les doigts de matériau gravable sont gravés simultanément.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 9 illustrent des étapes successives d'un procédé de fabrication de tranchées étroites selon la présente invention ;
la figure 10 représente la forme réelle des tranchées étroites obtenues selon le procédé principal de la présente invention ; et
les figures 11 à 14 illustrent un mode de réalisation particulier des dernières étapes d'un procédé selon la présente invention.

Les figures sont des vues en coupe du substrat initial et des différentes couches obtenues après chacune des étapes de fabrication de tranchées étroites selon la présente invention.

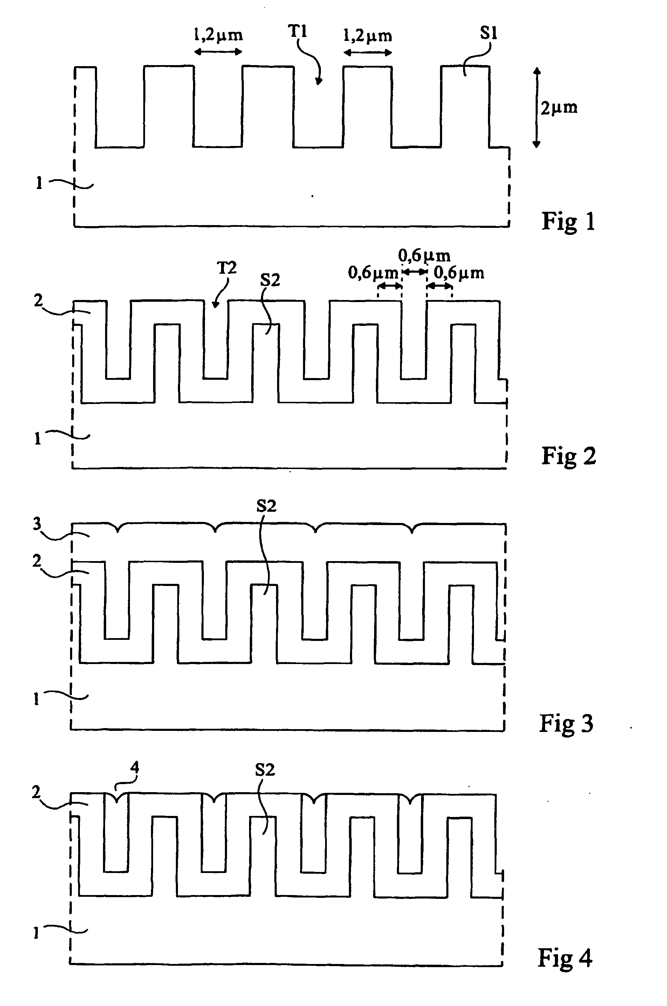

La figure 1 représente un substrat 1 dans lequel sont formées des tranchées T1. Ces tranchées ont été réalisées en utilisant un dispositif de lithographie et un procédé de gravure standard permettant au mieux d'obtenir des motifs de 1,2 µm de largeur et distants de 1,2 µm. Dans l'exemple illustré, on a formé des tranchées T1 d'une profondeur de 2 µm. Les tranchées T1 sont séparées par des nervures S1 du substrat.

A l'étape suivante, illustrée en figure 2, on procède à une oxydation thermique pour former une couche d'oxyde de silicium 2 ayant dans cet exemple une épaisseur de 0,6 µm. On obtient des tranchées T2 plus étroites que les tranchées initiales T1. Les nervures de substrat ont rétréci uniformément d'environ 0,3 µm formant des nervures de substrat S2 moins larges que les nervures de substrat initiales S1. De même, le fond des tranchées T1 s'est creusé de 0,3 µm. Au final, les tranchées T2 et les nervures S2 ont toutes une largeur égale à sensiblement 0,6 µm et sont séparées par une couche d'oxyde de silicium de sensiblement 0,6 µm de largeur.

A l'étape suivante, illustrée en figure 3, on dépose une couche de silicium 3, pour former dans cet exemple du silicium polycristallin, de façon à remplir totalement les tranchées T2 et à recouvrir la couche d'oxyde de silicium 2. L'épaisseur de la couche de silicium polycristallin 3 au dessus des nervures de substrat S2 est dans cet exemple au moins égale à 1,5 µm.

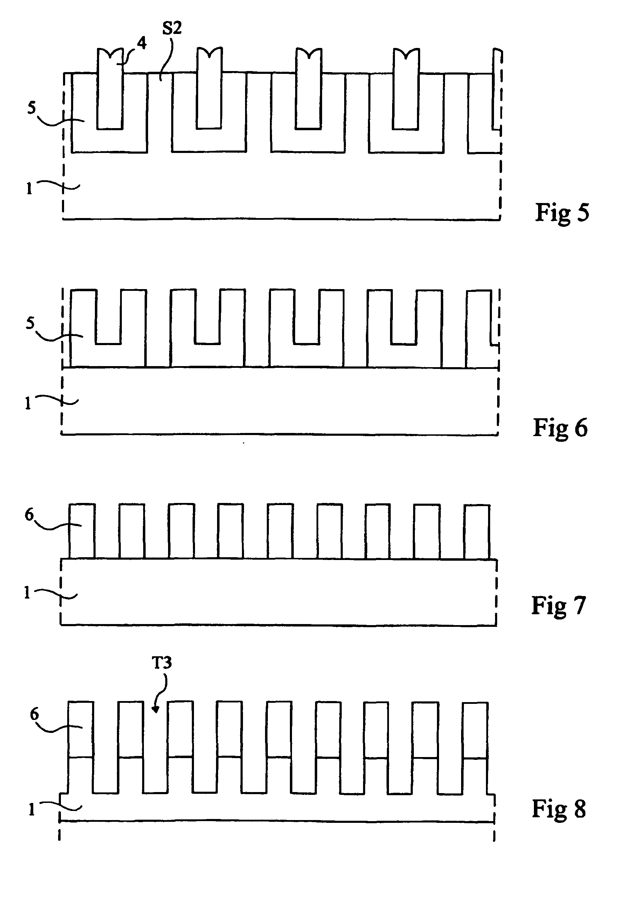

A titre de variante, on pourra déposer un autre matériau que du silicium. De préférence, on choisira un matériau pouvant être gravé selon le même procédé de gravure que le silicium avec une vitesse sensiblement identique afin de simplifier la partie du procédé décrit en relation avec la figure 6.

A l'étape suivante, illustrée en figure 4, on grave la couche de silicium polycristallin 3, de façon sélective par rapport à l'oxyde de silicium, jusqu'à découvrir l'oxyde de silicium 2 recouvrant les nervures de substrat S2. La gravure est alors interrompue de sorte qu'il reste des doigts 4 de la couche de silicium polycristallin 3 dans les tranchées T2.

A l'étape suivante, illustrée en figure 5, on grave de la couche d'oxyde de silicium 2 pendant une durée suffisante pour découvrir la partie supérieure des nervures S2. La gravure est sélective de façon à conserver intact les doigts de silicium polycristallin 4 ainsi que les nervures S2. On arrive ainsi à une structure telle que représentée en figure 5 dans laquelle les portions restantes 5 de la couche d'oxyde 2 ont une forme en U séparant les doigts 4 et les nervures S2.

A l'étape suivante, illustrée en figure 6, on grave le silicium afin de supprimer les nervures S2 et les doigts de silicium polycristallin 4. La gravure est sélective de façon à conserver intact les portions restantes 5 de la couche d'oxyde 2. Le temps de gravure est prévu pour éliminer complètement les doigts de silicium polycristallin 4 et pour que la gravure s'arrête approximativement au niveau de la base des nervures de silicium S2.

On prévoira éventuellement une étape de gravure supplémentaire, dans le cas où le matériau déposé dans les tranchées T2 ne se grave pas selon le procédé utilisé pour graver les nervures S2. L'étape de gravure supplémentaire devra néanmoins être une gravure sélective par rapport à la couche d'oxyde 2.

A l'étape suivante, illustrée en figure 7, on réalise une gravure anisotrope de l'oxyde de silicium, de façon sélective par rapport au silicium, pendant une durée permettant de découvrir le substrat 1 au fond des portions restantes 5 d'oxyde de silicium en U tout en laissant en place des doigts 6 d'oxyde de silicium. Dans le cadre de l'exemple numérique donné ci-dessus, le temps de gravure est prévu pour graver environ 0,6 µm d'oxyde de silicium.

A l'étape suivante, illustrée en figure 8, on réalise une gravure anisotrope des parties du substrat 1 non protégées par les doigts 6 d'oxyde de silicium.

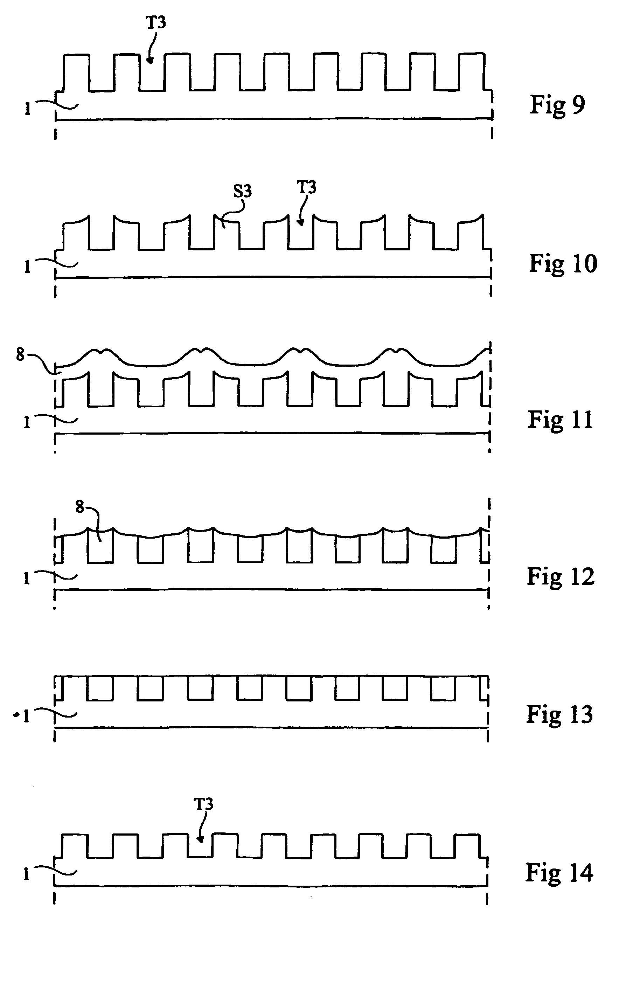

A l'étape suivante, illustrée en figure 9, on retire les doigts 6 d'oxyde de silicium.

On obtient ainsi des tranchées étroites T3 ayant une largeur d'environ 0,6 µm séparées par des nervures S3 ayant également une largeur d'environ 0,6 µm.

Ainsi, à partir d'une structure de tranchées réalisées avec un pas minimal de 1,2 µm, il est possible d'obtenir une structure comportant le double de tranchées avec un pas de 0,6 µm.

De façon générale, le procédé de la présente invention permet à partir d'une structure de tranchées réalisées avec un pas minimal correspondant à un appareil de lithographie donné d'obtenir une structure comportant le double de tranchées avec un pas deux fois plus petit.

On pourrait de plus prévoir de répéter le procédé décrit pour obtenir à nouveau le double de tranchées avec un pas de 0,3 µm et ainsi de suite.

Comme l'illustre la figure 10, en pratique, à l'étape décrite en relation avec la figure 9, on n'obtient pas la forme en créneau parfaitement régulière illustrée en figure 9 mais une forme irrégulière telle que celle illustrée en figure 10. La surface supérieure des nervures S3 n'est ni un plan horizontal ni une surface plane mais peut présenter des arêtes en relief. Dans le cas par exemple où l'on souhaite par la suite réaliser des condensateurs dont le diélectrique est constitué d'une fine couche recouvrant uniformément toute la surface de la structure de la figure 10, de telles irrégularités de surface peuvent poser problème. On prévoit alors d'aplanir la partie supérieure des nervures S3, par exemple selon le procédé illustré en relation avec les figures 11 à 14.

Dans une étape préliminaire, illustrée en figure 11, on dépose une couche d'oxyde 8 de façon à remplir totalement les tranchées étroites T3 et à recouvrir les nervures S3. L'épaisseur d'oxyde est dans cet exemple égale à 0,4 µm.

A l'étape suivante, illustrée en figure 12, on réalise une gravure sèche isotrope de l'oxyde 8 jusqu'à découvrir la partie supérieure des nervures S3 tout en conservant l'oxyde dans les tranchées étroites T3.

A titre de variante, on pourra remplacer l'oxyde 8 par un matériau pouvant être gravé sélectivement par rapport au substrat.

A l'étape suivante, illustrée en figure 13, on réalise un polissage mécano-chimique de façon à aplanir la partie supérieure de la structure.

A l'étape suivante finale, illustrée en figure 13, on retire l'oxyde 8. On obtient alors des tranchées étroites T3 séparées par des nervures S2 dont la partie supérieure est totalement plane.

Bien entendu, la présente invention est susceptible de diverses variantes et modifications qui apparaîtront à l'homme de l'art. En particulier, l'homme de l'art saura définir les épaisseurs d'oxyde, et de silicium polycristallin ainsi que la durée de gravure de ces derniers en fonction de la largeur, de l'espacement et de la profondeur des tranchées étroites souhaitées.

## Revendications

1. Procédé de formation de tranchées étroites dans un substrat de silicium (1), **caractérisé en ce qu'**il comprend les étapes suivantes :
- gravure du substrat pour former des premières tranchées (T1) séparées par des premières nervures de silicium (S1) ;
- oxydation thermique du substrat pour former une couche d'oxyde de silicium (2) se développant dans et à l'extérieur du silicium, d'où il résulte que l'on obtient des secondes tranchées (T2) plus étroites que les premières tranchées (T1) et des secondes nervures de silicium (S2) plus étroites que les premières nervures de silicium ;
- remplissage des secondes tranchées avec des doigts d'un matériau gravable ;
- gravure de l'oxyde de silicium jusqu'à la surface supérieure des secondes nervures en conservant des portions d'oxyde de silicium (5) entre lesdits doigts de matériau gravable et les secondes nervures ;
- élimination par gravure des secondes nervures de silicium et desdits doigts de matériau gravable ;
- gravure de l'oxyde de silicium pendant une durée suffisante pour découvrir le substrat au fond des portions d'oxyde de silicium, en laissant en place des doigts d'oxyde de silicium (6) ; et
- gravure anisotrope du substrat entre les doigts d'oxyde pour former des tranchées étroites (T3) dans le substrat.

2. Procédé selon la revendication 1, dans lequel l'étape de remplissage est effectuée selon les deux étapes suivantes :
- dépôt d'une couche de matériau gravable (3) remplissant totalement les secondes tranchées et recouvrant la couche d'oxyde de silicium ;
- gravure de ladite couche de matériau gravable pendant une durée suffisante pour laisser en place seulement des doigts (4) dans les secondes tranchées ;

3. Procédé selon la revendication 1, comprenant en outre une étape de retrait desdits doigts d'oxyde de silicium.

4. Procédé selon la revendication 3, comprenant en outre les étapes suivantes :
- dépôt d'une couche de remplissage (4) composée d'un matériau gravable sélectivement par rapport au substrat, la couche de remplissage remplissant totalement les tranchées étroites (T3) et recouvrant les nervures (S3) du substrat séparant les tranchées étroites ;
- gravure de la couche de remplissage jusqu'à découvrir les nervures du substrat, en conservant le matériau présent entre les nervures ;
- polissage mécano-chimique de la partie supérieure des nervures ; et
- retrait du matériau restant entre les nervures.

5. Procédé selon la revendication 1, dans lequel la largeur et l'espacement des premières tranchées sont identiques et dans lequel la durée de l'oxydation thermique du substrat est prévue de façon à obtenir des tranchées étroites sensiblement identiques.

6. Procédé selon la revendication 1, dans lequel le matériau gravable utilisé pour remplir les secondes tranchées est du silicium polycristallin.

7. Procédé selon la revendication 1, dans lequel les secondes nervures de silicium et les doigts de matériau gravable sont gravés simultanément.

## Patentansprüche

1. Verfahren zur Ausbildung schmaler Gräben in einem Siliziumsubstrat (1), **dadurch gekennzeichnet, dass** das Verfahren die folgenden Schritte aufweist:
Ätzen des Substrats zum Ausbilden erster Gräben (T1), die durch erste Siliziumrippen (S1) getrennt sind;
Durchführen einer thermischen Oxidation des Substrats zur Ausbildung einer Siliziumoxidschicht (2), die sich innerhalb und außerhalb des Siliziums ausbildet, wodurch zweite Gräben (T2) gebildet werden, die schmaler sind als die ersten Gräben (T1), und zweite Siliziumrippen (S2), die schmaler sind als die ersten Siliziumrippen;
Füllen der zweiten Gräben mit Fingern eines ätzbaren Materials;
Ätzen des Siliziumoxids auf bis zu der Oberfläche der zweiten Rippen, während die Siliziumoxidteile (5) zwischen den Fingern des ätzbaren Materials und den zweiten Rippen verbleiben;
Wegätzen der zweiten Siliziumrippen und der Finger aus ätzbaren Material;
Ätzen des Siliziumoxids für eine Zeitdauer, die ausreicht, um das Substrat am Boden der Siliziumoxidteile freizulegen, während Siliziumoxidfinger (6) verbleiben; und
anisotropes Ätzen des Substrats zwischen den Oxidfingern zur Ausbildung schmaler Gräben (T3) in dem Substrat.

2. Verfahren nach Anspruch 1, wobei der Schritt des Füllens die zwei folgenden Schritte aufweist:
Abscheiden einer Schicht eines ätzbaren Materials (3) zum vollständigen Füllen der zweiten Gräben und Abdecken der Siliziumoxidschicht; und
Ätzen der Schicht eines ätzbaren Materials für eine Zeitdauer, die ausreicht, um nur die Finger (4) in den zweiten Gräben verbleiben zu lassen.

3. Verfahren nach Anspruch 1, wobei ein zusätzlicher Schritt des Zurückätzens der Siliziumoxidfinger vorgesehen ist.

4. Verfahren nach Anspruch 3, das ferner die folgenden Schritte aufweist:
Abscheiden einer Füllschicht (4), die aus einem Material ausgebildet ist, das selektiv ätzbar ist bzgl. des Substrats, wobei die Füllschicht vollständig die schmalen Gräben (T3) ausfüllt und die Substratrippen (S3), welche die schmalen Gräben trennen, abdeckt;
Ätzen des Füllmaterials zum Freilegen der Substratrippen, während das Material zwischen den Rippen verbleibt;
Durchführen einer chemisch-mechanischen Politur des oberen Teils der Rippen; und
Zurückätzen des zwischen den Rippen verbliebenen Materials.

5. Verfahren nach Anspruch 1, wobei die Breite und der Abstand der ersten Gräben identisch ist und die Dauer der thermischen Oxidation des Substrats vorgesehen ist zum Erhalten im wesentlichen identischer schmaler Gräben.

6. Verfahren nach Anspruch 1, wobei das ätzbare Material das verwendet wird zum Füllen der zweiten Gräben Polysilizium ist.

7. Verfahren nach Anspruch 1, wobei die zweiten Siliziumrippen und die Finger des ätzbaren Materials simultan geätzt werden.

## Claims

1. A method for forming narrow trenches in a silicon substrate (1), **characterized in that** it comprises the steps of:
- etching the substrate to form first trenches (T1) separated by first silicon ribs (S1);
- performing a thermal oxidation of the substrate to form a silicon oxide layer (2) developing inside and outside of the silicon, whereby second trenches (T2) narrower than the first trenches (T1) and second silicon ribs (S2) narrower than the first silicon ribs are obtained;
- filling the second trenches with fingers of an etchable material;
- etching the silicon oxide down to the upper surface of the second ribs while keeping silicon oxide portions (5) between said etchable material fingers and the second ribs;
- etching away the second silicon ribs and said etchable material fingers;
- etching the silicon oxide for a duration sufficient to expose the substrate at the bottom of the silicon oxide portions, while leaving in place silicon oxide fingers (6); and
- anisotropically etching the substrate between the oxide fingers to form narrow trenches (T3) in the substrate.

2. The method of claim 1, wherein the filling step includes the two following steps:
- depositing a layer of an etchable material (3) totally filling the second trenches and covering the silicon oxide layer; and
- etching said layer of an etchable material for a duration sufficient to leave in place only fingers (4) in the second trenches.

3. The method of claim 1, wherein an additional step of etching back of said silicon oxide fingers is provided.

4. The method of claim 3, further comprising the steps of:
- depositing a filling layer (4) formed of a material selectively etchable with respect to the substrate, the filling layer totally filling the narrow trenches (T3) and covering the substrate ribs (S3) separating the narrow trenches;
- etching the filling layer to expose the substrate ribs, while keeping the material present between ribs;
- performing a chem-mech polishing of the upper portion of the ribs; and
- etching back the material remaining between the ribs.

5. The method of claim 1, wherein the width and the spacing of the first trenches are identical and the duration of the thermal oxidation of the substrate is provided to obtain substantially identical narrow trenches.

6. The method of claim 1, wherein the etchable material used to fill the second trenches is polysilicon.

7. The method of claim 1, wherein the second silicon ribs and the etchable material fingers are etched simultaneously.
